**Europäisches Patentamt**

**European Patent Office**

**Office européen des brevets**

(19)

(11) Veröffentlichungsnummer : **0 391 181 B1**

(12) **EUROPÄISCHE PATENTSCHRIFT**

(45) Veröffentlichungstag der Patentschrift :
**07.12.94 Patentblatt 94/49**

(51) Int. Cl.⁵ : **G01R 31/06, G01R 31/34**

(21) Anmeldenummer : **90105615.0**

(22) Anmeldetag : **24.03.90**

(54) **Anordnung zum Detektieren von Windungsschlüssen in der Rotorwicklung elektrischer Maschinen.**

(30) Priorität : **05.04.89 CH 1264/89**

(43) Veröffentlichungstag der Anmeldung :
**10.10.90 Patentblatt 90/41**

(45) Bekanntmachung des Hinweises auf die
Patenterteilung :
**07.12.94 Patentblatt 94/49**

(84) Benannte Vertragsstaaten :
**AT CH DE DK GB IT LI**

(56) Entgegenhaltungen :
**DE-A- 2 034 883**
**GB-A- 2 096 770**

(73) Patentinhaber : **ASEA BROWN BOVERI AG**
**Haselstrasse 16**
**CH-5401 Baden (CH)**

(72) Erfinder : **Posedel, Zlatimir**
**Feldhofweg 7**
**CH-5432 Neuenhof (CH)**

EP 0 391 181 B1

**Beschreibung**

**Anordnung zum Detektieren von Windungsschlüssen in der Rotorwicklung elektrischer Maschinen**

Technisches Gebiet

Die Erfindung bezieht sich auf eine Anordnung zum Detektieren von Windungsschlüssen in der Rotorwicklung elektrischer Maschinen durch Auswerten von Wellenspannungen oder Wellenströmen.

Die Erfindung nimmt dabei Bezug auf einen Stand der Technik, wie er sich beispielsweise aus dem Aufsatz "Rotor winding short detection" in "IEE Proceedings", Vol. 133, Pt. B, No. 3, May 1986, S. 181 - 189, ergibt.

Technologischer Hintergrund und Stand der Technik

Ein Windungsschluss in der Rotorwicklung einer elektrischen Mschine verursacht eine Unsymmetrie der Stromverteilung zwischen den Polen eines Generators.

Als Folge dieses Windungsschlusses entstehen

- unsymmetrische Erwärmungen des Rotors
- Kräfte durch die radiale magnetische Unsymmetrie
- Schlingströme in den Statorparallelleitern
- eine Magnetisierung der Welle durch axiale magnetische Unsymmetrie.

Mit steigender Maschinengrösse steigt auch die Wichtigkeit einer rechtzeitigen Rotorwindungsschlussdedektierung, sowie der Reparatur des Windungsschlusses.

Die Erfahrung hat gezeigt, dass Windungsschlüsse bei kritischer Konstellation im Betrieb zu ernsthaften Fehlern führen können.

Um Windungsschlüsse im Betrieb zu identifizieren und ihre zeitliche Veränderung zu beobachten, können im wesentlichen folgende Messmethoden verwendet werden.

- Detektierung des Windungsschlusses durch Messung der Unsymmetrie des magnetischen Streufeldes mittels einer im Luftspalt der Maschine (nahe zur Rotoroberfläche) eingebauten Messspule. Das magnetische Streufeld ist direkt proportional den Amperewindungen in einer Nut
- Detektierung des Windungsschlusses während des Betriebes durch die Messung der Schlingströme in den Statorparallelleitern. Bei einer magnetischen Unsymmetrie des Rotors durch den Windungsschluss induzieren sich in den Statorparallelleitern verschiedene Spannungskomponenten.
- Detektieren des Windungsschlusses durch Beaufschlagen der Rotorwicklung mit Spannungspulsen und Auswertung des zeitlichen Verlaufes der Stosswellen.

Diese und weitere Messmethoden sind beschrieben in dem Aufsatz "Rotor winding short detection" in IEE Proceedings, Vol. 133, PT. B. No. 3, May 1986, Seiten 188 - 189.

Die Methode mit Messsonde im Luftspalt birgt Gefahren in sich, verlangt eine aufwendige konstruktive Lösung und erfordert eine relativ komplizierte Auswertung der Messsignale.

Auch die zweite Methode erfordert eine konstruktive Lösung für die Anbringung der zwei hochspannungsisolierten, um die Statorleiter gewickelten Messspulen (Rogowskispulen) und eine harmonische Auswertung des Statorstromes.

Diese Methode ist für die im Betrieb befindlichen Maschinen fragwürdig.

Kurze Darstellung der Erfindung

Ausgehend vom Bekannten liegt der Erfindung die Aufgabe zugrunde, eine Anordnung zum Detektieren von Windungsschlüssen in der Rotorwicklung elektrischer Maschinen zu schaffen, die betriebssicher ist, keine konstruktive Anordnungen in der Maschine erfordert und sowohl als permanente Überwachung im Rahmen des allgemeinen "Monitoring" als auch zur ad hoc-Diagnose herangezogen werden kann.

Die Lösung dieser Aufgabe ist erfindungsgemäss vorgesehen, die Maschinenwelle an der Antriebsseite unmittelbar geerdet ist, an der Nichtantriebsseite ein Spannungsmessglied zur Erfassung der Wellenspannung zwischen Maschinenwelle und Erde vorgesehen ist, und dass die durch Windungsschlüsse in dem Wellenspannungssignal hervorgerufenen Harmonischen $f_H = (n\pm 1)^* f/p$, wobei p die Polpaarzahl der Maschine, n = p, 3p,5p,.. und f die Netzfrequenz bedeutet, in einer Auswerteeinheit ermittelt werden.

Die Anordnung zur Ermittlung von Windungsschlüssen im Betrieb beruht auf der Erkenntnis, dass ein Rotorwindungsschluss in den Wellenspannungen diese Harmonischen induziert, z.B. ist bei einer zweipoligen 50-Hz-Maschine $f_H = 100$ Hz, 200 Hz, 300 Hz,.., bei einer vierpoligen 50-Hz-Maschine ist $f_H = 25$ Hz, 75 Hz, 125 Hz,..

Bei einem Generator ohne Rotorwindungsschluss ist der magnetische Fluss von den Polen symmetrisch. Durch aussermittige Lagerung (statische Exzentrizität) entsteht bei elektrischen Maschinen hauptsächlich zwischen Maschinenwelle und Erde eine Wellenlängsspannung, die aber nur ungeradzahlige Harmonische enthält.

Bei einem Windungsschluss in der Rotorwicklung entsteht, bezogen auf die Welle, längs der Welle des Generators eine Wechselspannung (Wellenlängsspannung), die auch die geraden oder bruchzahligen Harmonischen induziert.Aus diesem Zusammenhang heraus wird mit der neuen Anordnung das Erscheinen eines Windungsschlusses durch Messung der gerad- oder bruchzahligen Harmonischen der Wellenlängsspannung festgestellt.

Eine dynamische Exzentrizität der Maschine induziert zwar auch geradzahlige Harmonische in der Wellenspannung, doch unterscheidet sich die Grösse und die spektrale Verteilung von denjenigen Komponenten, die bei Windungsschlüssen entstehen.

Die Erfindung hat gegenüber bestehenden Methoden der Rotorwindungsschlusserkennung den grossen Vorteil, dass sie an allen Maschinen im Betrieb permanent für die Überwachung und auch von Zeit zu Zeit für die Durchführung von Diagnosen angeschlossen werden kann, da es keine konstruktiven Anordnungen in der Maschine verlangt.

Kurze Beschreibung der Zeichnung

In der Zeichnung ist ein Ausführungsbeispiel der Erfindung dargestellt; dabei zeigt

Fig.1    eine stark schematisierte Darstellung einer Turbogruppe mit einer Anordnung zur Detektion von Windungsschlüssen in der Rotorwicklung;

Fig.2    ein Diagramm, das die Rotordurchflutung eines zweipoligen Turbogenerators mit und ohne Spulenschluss veranschaulicht;

Fig.3    ein Diagramm zur Verdeutlichung der Wellenlängsspannung eines zweipoligen Turbogenerators ohne Windungsschluss;

Fig.4    ein Diagramm zur Verdeutlichung der Wellenlängsspannung eines zweipoligen Turbogenerators mit Windungsschluss;

Fig.5    ein Diagramm, das die harmonische Analyse der Wellenspannung eines zweipoligen Turbogenerators ohne Windungsschluss zeigt;

Fig.6    ein Diagramm, das die harmonische Analyse der Wellenspannung eines zweipoligen Turbogenerators mit Windungsschluss zeigt;

Fig.7    das Blockschaltbild der Anordnung zur Windungsschlussüberwachung.

Wege zur Ausführung der Erfindung

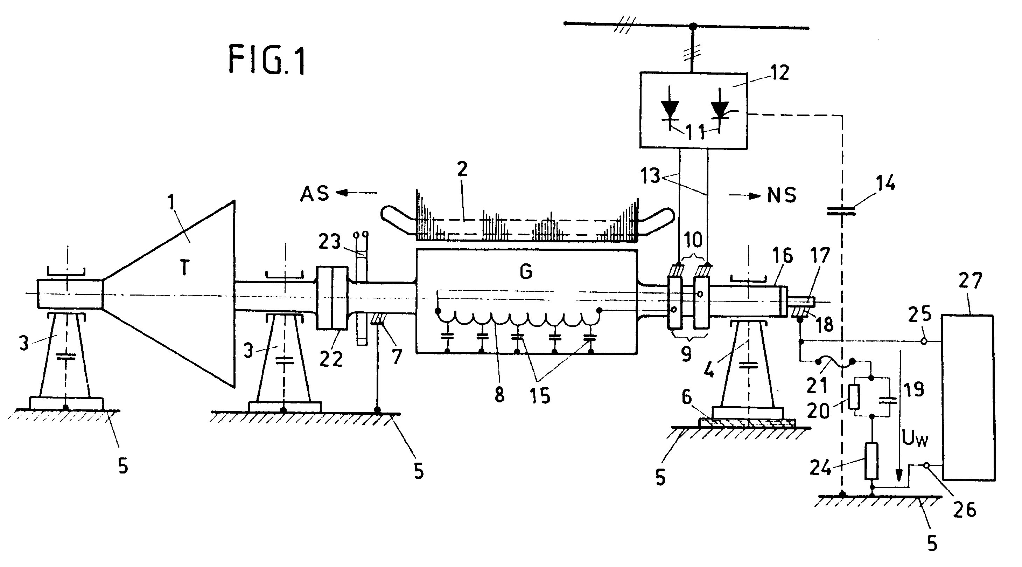

In Fig. 1 ist eine Turbogruppe mit einer Turbine 1 und einem Generator 2 dargestellt. Anstelle des Generators 2 ist jedoch auch eine andere elektrische Maschine, z.B. ein Schleifringläufer-Asynchronmotor, und anstelle der Turbine 1 eine beliebige angetriebene Arbeitsmaschine denkbar. Mit 3 sind die auf der Antriebsseite (AS) gelegenen und gegenüber Erde 5 (Masse) nicht isolierten Lager des Wellenstranges bezeichnet, 4 ist das auf der Nicht-Antriebsseite (NS) gelegene und über eine Lagerisolation 6 gegen Erde 5 isolierte Lager. Auf AS ist der Wellenstrang über eine Erdungsbürste 7 ohmisch geerdet. Die Rotorwicklung 8 wird über Schleifringe 9 und Stromabnahmebürsten 10 aus dem statischen, d.h. mit Halbleiterventilen 11 (nur symbolisch dargestellt) ausgerüsteten Speisesystem 12 über Zuleitungen 13 angespeist.

Auf der NS-Seite bzw. jenem Wellenende 16, an welchem die Lager (Dichtringe usw.) über die Isolierstrecken 6 gegen Erde 5 isoliert sind, ist eine Messeinrichtung für die Wellenspannung vorgesehen. Die Wellenspannung wird im einfachsten Fall mittels Bürsten 18 erfasst. Bei einer Maschine mit Erdung über ein RC-Glied auf der NS-Seite, wie sie im Beispielsfall dargestellt ist, kann die Wellenspannung unmittelbar zwischen der Bürste 18 und Erde 5 abgegriffen werden. Die Erdung besteht hier aus einem Gleitkontakt mit einem rotierenden Kontaktteil an einem Wellenzapfen 17 und einem feststehenden Kontakt, den Bürsten 18, einem Kondensator 19 und einem parallel hierzu geschalteten ohmschen Widerstand 20. Eine in Serie zu dem RC-Glied 19, 20 geschaltete Sicherung 21 hat die Aufgabe, bei einem Isolationsdefekt des ohmschen Widerstandes oder der Kapazität den Fluss von Strömen zu verhindern, welche in diesem Fall von niederfrequenten Längsspannungen getrieben würden. Hierzu werden vorzugsweise träge Sicherungen für möglichst kleine Abschaltströme eingesetzt, die jedoch auf die sehr kurzzeitigen kapazitiven Ableitströme nicht ansprechen. Für die Auslegung des Kondensators 19 und des ohm'schen Widerstandes 20 gelten folgende Kriterien:

Einerseits soll diese Erdung eine möglichst niedrige Impedanz zur Ableitung der steilen Spannungsspitzen haben, andererseits soll der durch niederfrequente Wellenspannungskomponenten (Drehfrequenz und Ober-

wellen) verursachte Strom bei einem auf der anderen Seite -AS- vorhandenen Kontakt klein sein, Widerstandswerte zwischen 400 und 1000 Ohm und Kapazitätswerte zwischen 1 und 30 Mikrofarad haben sich dabei als besonders zweckmässig erwiesen.

Für den Gleitkontakt im NS-seitigen Ableitkreis müssen folgende Anforderungen erfüllt sein:

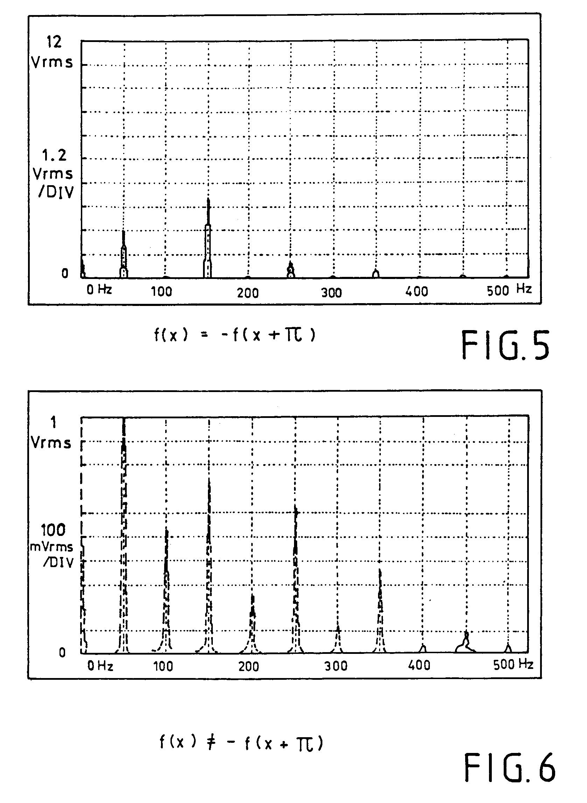

- Eine kleine Gleitgeschwindigkeit, was z.B. durch einen Wellenzapfen 17, dessen Durchmesser kleiner ist als derjenige der Welle, erreicht werden kann;
- eine für die Ableitung kurzer Stromimpulse günstig strukturierte Oberfläche des rotierenden Kontaktteiles, z.B. durch Strukturierung der Zapfenoberfläche, vorzugsweise nach Fig. 5 der DE-OS 35 11 755;
- Bürsten mit gleichbleibenden mechanischen und elektrischen Eigenschaften, z.B. solche aus metallisierten Carbonfiltern oder Metall, die entweder radial oder axial am Wellenzapfen 17 aufliegen.

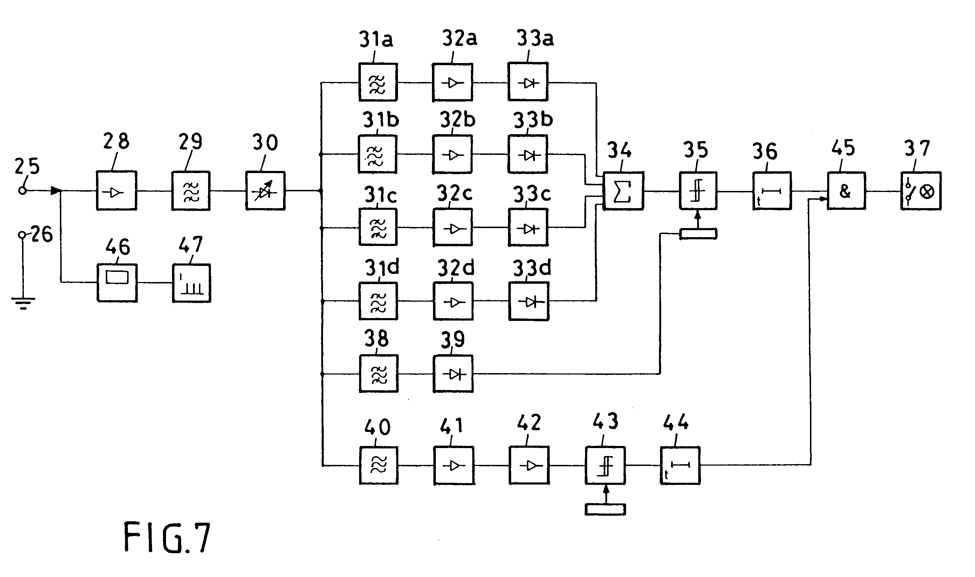

In Serie zum RC-Glied 19, 20 liegt ferner ein induktivitätsarmer Messwiderstand (Shunt) 24 zur Erfassung des gesamten Wellenableitstromes, der von der NS-Seite zur Erde fliesst. Über Klemmen 25, 26, die unmittelbar an die Bürsten 18 den Verbindungspunkt zwischen RC-Glied 20, 19 und Messwiderstand und Masse (Fundament 5) führen, ist eine Auswerteeinheit 27 angeschlossen, deren Aufbau aus Fig. 7 hervorgeht.

Ein die Welle zwischen AS-Erdungsbürste 7 und Kupplung 22 umgebender Stromwandler, vorzugsweise eine Rogowski-Spule 23, dient gleichfalls der Erfassung des Wellenstroms und kann einer Überwachungsrichtung zugeleitet werden.

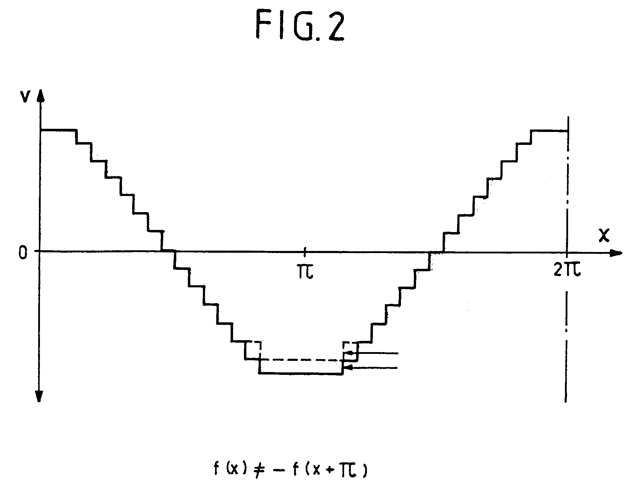

Das Prinzip der Rotorwindungsschlussüberwachung basiert auf der zweckmässigen Auswertung der im Betrieb auftretenden Harmonischen der Wellenspannung. Bei einem windungsschlussfreien Rotor ist die Verteilung der Amperewindungen am Rotorumfang symmetrisch und das Rotorfeld der Maschine hat nur die ungeradzahligen Harmonischen. Wenn ein Windungsschluss in der Rotorwicklung eines Turbogenerators auftritt, entsteht eine Unsymmetrie in der Umfangsverteilung der Amperewindungen (Fig. 2 - ausgezogene Kurve ohne, strichlierte Kurve mit Windungsschluss)

$$v(x + \pi) \neq - v(x)$$

und das Rotorfeld der Maschine beinhaltet auch die geradzahligen Harmonischen. Durch radiale magnetische Unsymmetrie der Maschine, hauptsächlich durch statische Exzentrität des Rotors verursacht, tritt eine Wellenlängsspannung auf, die bei einem windungsschlussbehafteten Rotor geradzahlige Harmonische hat.

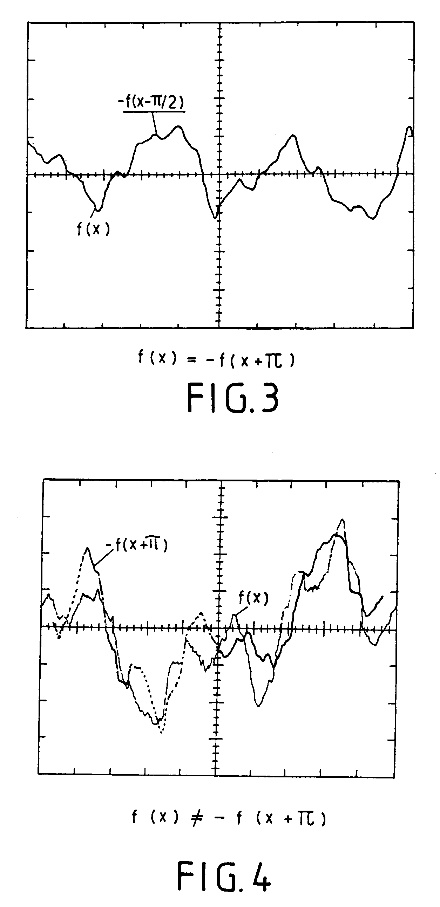

In den Figuren 3 und 4 sind die Verläufe der Wellenlängsspannung eines zweipoligen Turbogenerators ohne Windungsschluss (Fig.3) und mit Windungsschluss (Fig,4) einander gegenübergestellt.

Die Amplitudenauswertung der geradzahligen Harmonischen liefert eine Aussage über das Vorhandensein des Windungsschlusses in Rotorwicklung des Turbogenerators (Fig.5 und 6).

Fig. 7 zeigt in Form eines Blockschaltbildes die Auswerteeinheit 27 der Fig.1.

Das an den Klammern 25 und 26 anliegende Eingangssignal $U_w$ wird in einem Speicherglied 28 gespeichert und verstärkt, dann via Bandpaßfilter 29 und einem Verstärker 30 mit einstellbarer Verstärkung auf parallele Bandpaßfilter 31a, 31b, 31c und 31 d weitergeleitet. Jedes Bandpaßfilter ist auf eine geradzahlige Harmonische der Grundfrequenz der Wellenspannung abgestimmt; Bei einer zweipoligen 50 Hz-Maschine (Polpaarzahl p = 1) sind die Bandpaßfilter 31a, 31b, 31c, 31d demgemäss auf die geradzahligen Harmonischen 100 Hz, 200 Hz, 300 Hz und 400 Hz abgestimmt. Bei einer vierpoligen Maschine (Polpaarzahl p = 2) sind die Bandpaßfilter dementsprechend auf die bruchzahligen Harmonischen 25 Hz,75 Hz, 125 Hz und 175 Hz abgestimmt. Jede dieser Harmonischen wird in nachgeschalteten Verstärkern 32a, 32b, 32c und 32d schmalbandig verstärkt und anschliessend in Gleichrichtern 33a, 33b, 33c und 33d gleichgerichtet. Alle geradzahligen bzw. bruchzahligen Harmonischen werden nach Summierung in einem Summierglied 34 einem Spannungskomparator 35 zur Bewertung zugeführt.

Wenn die Summe der geradzahligen Harmonischen das eingestellte Niveau überschreitet, erfolgt über ein Verzögerungsrelais 36 der Alarm an einer Signaleinheit 37. Der eingestellte Niveauwert ist von der gesamten Wellenspannungsgrösse abhängig, die über einen breitbandigen Filter 38 und Gleichrichter 39 erfasst wird. Eine Auswertung zwischenharmonischer Amplituden in einem Hilfspfad, bestehend aus einem Filter mit Bandpass-Charakteristik 40, Verstärker 41, Gleichrichter 42, Spannungskomparator 43 und Verzögerungsrelais 44 verhindert eine Fehlinterpretation durch Verriegelung des Alarmsignals im UND-Glied 45 bei schlechtem Mess- oder Erdungsbürstenkontakt. Das Filter 40 ist bei einer zweipoligen Maschine auf etwa 75 Hz, bei einer vierpoligen Maschine etaw auf 100 Hz abgestimmt.

Der Hardware-Aufwand wird drastisch reduziert, wenn die dargestellte Wellenspannungsauswertung durch einen Mikroprozessor ersetzt wird.

Die Ausgabeeinheit 37 kann bei Bedarf durch ein geeignetes Modem ersetzt werden.

Eine tiefere Analyse der Wellenspannung ist durch Einbezug eines Spektrum-Analysierers 46 mit angeschlossenem Drucker 47 am Signaleingang des Überwachungsgerätes möglich.

**Patentansprüche**

1. Anordnung zum Detektieren von Windungsschlüssen in der Rotor-wicklung elektrischer Maschinen durch Auswerten von Wellenspannungen oder Wellenströmen, dadurch gekennzeichnet, dass die Maschinenwelle an der Antriebsseite (AS) unmittelbar geerdet, an der Nichtantriebsseite (NS) ein Spannungs-Messglied (20) zur Erfassung der Wellenspannung ($U_w$) zwischen Maschinenwelle und Erde (5) vorgesehen ist, und dass die durch Windungsschlüsse in dem Wellenspannungssignal hervorgerufenen Harmonischen $f_H = (n \pm 1)*f/p$, wobei p die Polpaarzahl der Maschine, n = p, 3p,5p,... und f die Netzfrequenz bedeutet, in einer Auswerteeinheit (27) ermittelt werden.

2. Anordnung nach Anspruch 1, dadurch gekennzeichnet, dass die Auswerteeinheit (27) parallelgeschaltete Bandpassfilter (31a, 31b, 31c, 31d) aufweist, welche auf die geradzahligen oder bruchzahligen Harmonischen der Wellenspannung ($U_w$) abgestimmt sind.

3. Anordnung nach Anspruch 2, dadurch gekennzeichnet, dass die Ausgangssignale der Bandpassfilter nach Gleichrichtung einem Summierglied zugeführt sind und das Summensignal mit einem Referenzsignal verglichen wird.

4. Anordnung nach Anspruch 3, dadurch gekennzeichnet, dass die Auswerteeinheit (27) einen Hilfspfad (40, 41, 42, 43, 44) zur Erfassung nichtharmonischer Komponenten des Wellenspannungssignals umfasst zur Verriegelung des Alarmsignals bei Kontaktproblemen auf der Antriebs (AS)- und/oder Nichtantriebsseite (NS).

**Claims**

1. Arrangement for detecting winding shorts in the rotor winding of electrical machines by analyzing shaft voltages or shaft currents, characterized in that the machine shaft is directly earthed at the drive end (DE), a voltage measuring element (20) is provided at the non-drive end (NE) for recording the shaft voltage ($U_w$) between the machine shaft and earth (5) and in that the harmonics $f_H = (n \pm 1)*f/p$ produced in the shaft voltage signal by winding shorts, p denoting the number of pairs of poles of the machine, n = p, 3p, 5p, ... and f denoting the mains frequency, are determined in an analysis unit (27).

2. Arrangement according to Claim 1, characterized in that the analysis unit (27) has parallel-connected band-pass filters (31a, 31b, 31c, 31d) which are tuned to the even or fractional harmonics of the shaft voltage ($U_w$).

3. Arrangement according to Claim 2, characterized in that the output signals of the band-pass filters are fed, after rectification, to a summation element and the summated signal is compared with a reference signal.

4. Arrangement according to Claim 3, characterized in that the analysis unit (27) includes an auxiliary path (40, 41, 42, 43, 44) for recording non-harmonic components of the shaft voltage signal in order to lock the alarm signal in the case of contact problems at the drive end (DE) and/or non-drive end (NE).

**Revendications**

1. Disposition pour la détection des courts-circuits entre les spires dans les enroulements de rotor de machines électriques par appréciation des tensions ondulatoires ou des courants ondulatoires, caractérisée par le fait que l'arbre de la machine est mis immédiatement à la terre côté entraînement (AS) ; sur le côté opposé à l'entraînement (NS), un élément de mesure de la tension (20) est prévu, pour la saisie de la tension ondulatoire ($U_w$) entre l'arbre de la machine et la terre (5), et que les harmoniques $f_H = (n \pm 1)*f/p$ provoquées par les courts-circuits entre les spires dans le signal de tension ondulatoire sont déterminsées dans une unité d'appréciation (27), p représentant le nombre de paires de pôles de la machine, n = p, 3p, 5p,... et f la fréquence du réseau.

2. Disposition selon revendication 1, caractérisée par le fait que l'unité d'appréciation (27) présente des filtres passe-bande branchés en parallèle (31a, 31b, 31c, 31d), qui sont adaptés en fonction des harmoniques paires ou fractionnaires de la tension ondulatoire ($U_w$).

3. Disposition selon la revendication 2, caractérisée par le fait que les signaux de sortie des filtres passebande sont amenés après redressement à un additionneur et que le signal de somme est comparé à un signal de référence.

4. Disposition selon revendication 3, caractérisée par le fait que l'unité d'appréciation (27) englobe un chemin auxiliaire (40, 41, 42, 43, 44) pour la saisie des composantes non harmoniques du signal de la tension ondulatoire pour le verrouillage du signal d'alarme en cas de problèmes de contact du côté de l'entraînement (AS) et/ou du côté opposé à l'entraînement (NS).

FIG.1

# FIG.2

$$f(x) \neq -f(x+\pi)$$

$$f(x) = -f(x+\pi)$$

## FIG.3

$$f(x) \neq -f(x+\pi)$$

## FIG.4

$$f(x) = -f(x + \pi)$$

FIG.5

$$f(x) \neq -f(x + \pi)$$

FIG.6

FIG.7